# FASCICULE DE BREVET EUROPEEN

(11) **EP 0 561 456 B1**
(45) Date de publication et mention de la délivrance du brevet: **24.09.1997**
(21) Numéro de dépôt: 93200711.5
(22) Date de dépôt: 11.03.1993
(51) Int. Cl.: G05F 3/26, H03K 17/04, H03L 7/089

(54) **Miroir de courant à commutation accélérée**
Schneller Schaltstromspiegel
Fast switching current mirror using such a synthesizer

(30) Priorité: 18.03.1992 FR 9203247
(43) Date de publication de la demande: 22.09.1993
(73) Titulaire: PHILIPS COMPOSANTS ET SEMICONDUCTEURS, 92150 Suresnes (FR); Philips Electronics N.V., 5621 BA Eindhoven (NL)
(72) Inventeur: Dufour, Yves, F-75008 Paris (FR)
(74) Mandataire: Charpail, François

(56) Documents cités:
- EP-A- 0 173 367
- EP-A- 0 405 523
- JP-A-60 237 718
- US-A- 4 525 682
- US-A- 4 544 878
- PATENT ABSTRACTS OF JAPAN vol. 10, no. 95 (E-395)(2152) 12 Avril 1986

## Description

La présente invention concerne un miroir de courant comprenant d'une part, une branche de commande qui comporte en série entre une borne d'alimentation et une borne de référence de tension
- une source de courant de commande qui peut prendre deux états dont le premier correspond à une valeur de courant dite nominale et le second correspond à une valeur de courant faible ou nulle,
- le trajet principal de courant d'au moins un premier transistor,
- et une première résistance d'équilibrage,
et d'autre part, une branche de sortie qui comporte un deuxième transistor, prévu pour fournir un courant dont la valeur est en relation déterminée avec le courant de commande, et dont l'électrode de référence est reliée à la borne de référence de tension à travers une deuxième résistance d'équilibrage, les électrodes de commande des premier et deuxième transistors étant interconnectées et polarisées à partir du courant de commande.

Il existe une variété de formes de réalisation de miroirs de courant dont la plus simple est constituée de deux transistors seulement, le transistor de la branche de commande étant connecté en diode. Une autre forme également très connue, utilise trois transistors, le noeud commun aux bases des premier et deuxième transistors étant alimenté à l'aide d'un troisième transistor, monté en amplificateur, dans la branche de commande du miroir, pour l'alimentation des bases du miroir.

Selon l'une ou l'autre de ces deux formes simples de réalisation, le courant de sortie du miroir de courant présente un temps de descente qui est relativement lent, dans sa partie finale, lorsque le courant de commande du miroir est commuté de sa valeur nominale à une valeur nulle. Ce phénomène est principalement dû à la décharge des capacités parasites du circuit, par exemple celle de la source de courant de commande. Or cette décharge s'opère à travers une diode base-émetteur d'un transistor bipolaire ou à travers la résistance de canal d'un transistor à effet de champ, dont l'impédance s'accroît au fur et à mesure que le courant de décharge diminue.

Un exemple de miroir de courant présentant un courant de sortie à temps de descente réduit est fourni par le document US 4 525 682. Le miroir connu utilise deux sources de courant additionnelles qui doivent être exactement appairées si on désire obtenir en sortie une copie précise du courant de commande.

L'invention concerne également un synthétiseur de fréquence mettant en oeuvre un miroir de courant à commutation accélérée ainsi qu'un appareil radio-mobile comprenant un tel synthétiseur.

Parmi les modes de construction d'un synthétiseur de fréquence, on peut utiliser un circuit appelé pompe de charges qui met en oeuvre au moins un miroir de courant.

Il est connu de le réaliser avec deux sources de courant de construction similaire, le courant de l'une d'entre elles étant appliqué à la charge d'un condensateur et le courant de l'autre à sa décharge, après inversion par un miroir de courant. Lorsque la tension de charge du condensateur est stabilisée, la somme algébrique des courants fournis au condensateur par les deux sources commutables doit être voisine de zéro et l'effet de ralentissement susmentionné, dû au miroir de courant, représente donc un inconvénient majeur pour la stabilité de la tension de charge du condensateur. Ce défaut se traduit par une variation cyclique de tension, équivalente à un bruit exagéré dans le circuit de contrôle du verrouillage de phase.

Selon l'invention, un miroir de courant à commutation accélérée qui ne nécessite pas de sources de courant additionnelles appairées comme dans le miroir connu, est défini selon la revendication 1.

La décroissance du courant de sortie, dans le circuit selon l'invention, est accélérée du fait que lorsque les premier et deuxième transistors deviennent faiblement conducteurs (et que leur impédance interne s'accroît), c'est le transistor additionnel qui devient alors conducteur et évacue par son trajet principal de courant, les charges de la capacité parasite de la source de courant de commande. Si on compare la décroissance de courant de sortie du circuit selon l'invention avec celle d'un circuit miroir de courant classique, l'accélération observée avec le circuit de l'invention est d'autant plus significative que l'observation est faite à plus bas niveau de courant. Très approximativement, on peut assimiler la décroissance finale du courant dans le circuit de l'invention à une fonction linéaire tandis que celle utilisant un miroir de courant classique serait d'un type assymptotique. On comprendra que le changement d'état du transistor additionnel découle directement de la variation de tension aux bornes de la première résistance d'équilibrage.

Pour bénéficier au mieux de cet effet, on choisit avantageusement la valeur de cette première résistance d'équilibrage telle que la chute de tension dans celle-ci, sous l'effet du courant nominal de commande, soit supérieure à 80 mV. Dans le cas où des transistors bipolaires sont utilisés, si on choisit par exemple une chute de tension de 150 mV, le courant dévié vers la borne de référence, par le transistor additionnel, est une fraction tout à fait négligeable (moins de 1 %) de la valeur du courant de commande nominal. Lorsque le courant de commande est stabilisé à zéro, le transistor additionnel débite, par sa jonction émetteur-base, un courant qui n'est qu'une petite fraction du courant de commande nominal, par exemple 10 %, ou moins, de ce courant. C'est pourquoi la taille du transistor additionnel peut être choisie plus petite que celle des premiers et deuxièmes transistors. L'invention met donc en oeuvre des moyens qui n'augmentent pas sensiblement la surface de semiconducteur nécessaire au circuit et est donc, de ce fait, économique.

Pour ne pas affecter le temps de montée du circuit selon l'invention, on prévoit avantageusement de munir le transistor additionnel d'un dispositif anti-saturation tel qu'une diode Schottky connectée en parallèle sur le circuit base-collecteur de ce transistor additionnel.

Une autre variante de mise en oeuvre de l'invention, toujours dans le cas où des transistors bipolaires sont utilisés, se caractérise en ce que le dispositif anti-saturation est constitué d'un transistor supplémentaire, de même polarité que les autres transistors, dont l'émetteur est connecté au collecteur du premier transistor et à celui du transistor additionnel, dont la base est polarisée à une autre tension fixe qui dépasse la tension fixe précédemment mentionnée d'une fraction d'une tension de jonction polarisée en direct, et dont le collecteur est alimenté à partir de la borne d'alimentation.

L'invention n'est pas limitée au cas d'utilisation de transistors bipolaires. Elle peut également être mise en oeuvre à l'aide de transistors à effet de champ, ou encore à l'aide d'une combinaison de transistors bipolaires et de transistors à effet de champ, ces derniers, de type MOS par exemple.

Ainsi, selon une variante avantageuse de l'invention, le miroir de courant est réalisé avec des transistors bipolaires, et se caractérise en ce que le transistor additionnel est un transistor à effet de champ dont le trajet drain-source est connecté en parallèle sur le trajet collecteur-émetteur du premier transistor.

Ladite tension fixe déterminée peut être alors fournie simplement par un autre transistor à effet de champ, dont le drain et la grille sont interconnectés et alimentés à partir de la borne d'alimentation par un courant fixé, tandis que la source de cet autre transistor est reliée à la borne de référence de tension, ladite tension fixe déterminée étant disponible sur le noeud drain-grille dudit autre transistor.

La description qui va suivre, en regard des dessins annexés, donnés à titre d'exemples non limitatifs, fera bien comprendre en quoi consiste l'invention et comment elle peut être réalisée.

La figure 1 montre un schéma simplifié, sous forme de blocs, d'un synthétiseur de fréquence, et la figure 2 un schéma similaire, relatif à un appareil radio mobile.

La figure 3 représente un schéma électrique d'un premier exemple de circuit selon l'invention, dans une version à transistors bipolaires.

La figure 4 est un diagramme montrant la variation au cours du temps, du courant de sortie du circuit de la figure 1 en comparaison avec la variation de courant correspondante dans un miroir de courant connu.

La figure 5 montre le schéma d'un deuxième exemple de circuit selon l'invention qui est muni d'un dispositif anti-saturation.

La figure 6 donne le schéma d'un troisième exemple de circuit selon l'invention, également muni d'un dispositif anti-saturation, et

la figure 7 montre le schéma d'un quatrième exemple de circuit selon l'invention dans une version mixte : transistors bipolaires et transistors à effet de champ.

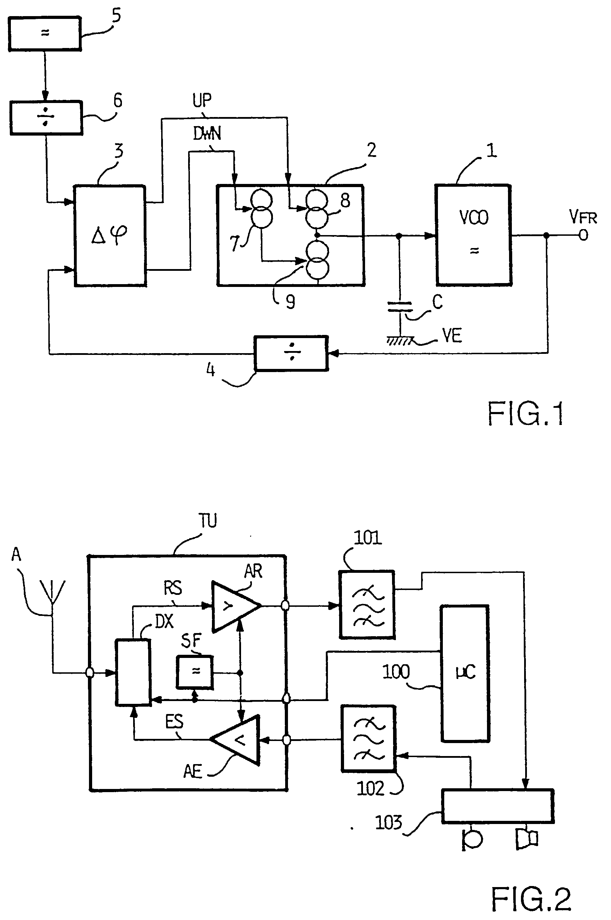

Un exemple de synthétiseur de fréquence est brièvement décrit à l'aide de la figure 1.

Un oscillateur 1 dont la fréquence est modifiable par une tension Vv, délivre un signal de sortie Vfr.

La tension Vv est établie aux bornes d'une capacité C, référencée par ailleurs à la masse (V_{E}), au moyen d'un circuit pompe de charges 2, lequel reçoit une commande de montée (UP) et une commande de descente (DWN) provenant d'un comparateur de phase 3.

Aux deux entrées du comparateur de phase 3, sont appliqués respectivement, d'une part le signal de sortie Vfr, après division de fréquence par un premier diviseur 4, et d'autre part, le signal délivré par un oscillateur de référence 5, après division de fréquence par un deuxième diviseur 6.

L'invention s'applique particulièrement (mais non exclusivement) à un synthétiseur de fréquence dans lequel la pompe de charges 2 comporte deux sources de courant semblables 7, 8, commandées par les signaux respectifs UP et DWN modulés en durée, et dans lequel le courant de sortie de la source de courant 7 est inversé de sens par un miroir de courant 9 pour réaliser l'absorption de courant sur la capacité C.

Dans ce qui suit, il sera particulièrement question du miroir de courant 9, réalisant la décharge de la capacité C.

La figure 2 montre de manière très schématique, de quelle manière un synthétiseur de fréquence est utilisé au sein d'un appareil radio-mobile.

Un signal d'antenne A est appliqué à l'entrée d'un circuit syntoniseur TU, lequel comporte un dispositif de multiplexage DX, pour un partage de signaux de réception RS, et d'émission ES. Les signaux de réception RS sont amplifiés et démodulés par un circuit propre à la réception AR, tandis que les signaux d'émission ES sont délivrés en sortie d'un circuit d'amplification et de mise en forme AE, propre à l'émission.

Le circuit syntoniseur TU, comporte encore un synthétiseur de fréquence SF dont le signal de sortie est appliqué aux circuits AR et AE pour la sélection des canaux de réception et d'émission, respectivement.

L'appareil comporte en outre un microcontrôleur 100 muni d'organes de contrôle non représentés (clavier par exemple) lequel assure la gestion des fonctions générales de l'appareil et en particulier la commande du synthétiseur de fréquence SF et éventuellement du dispositif de multiplexage Dx. Un filtre 101 est inséré dans la voie de réception, entre le circuit AR du syntoniseur TU et un combiné microphone-écouteur 103, et un filtre 102, est inséré dans la voie d'émission, entre le même combiné 103 et le circuit AE du syntoniseur TU. En bref, le synthétiseur de fréquence SF fournit des signaux Vfr dont la fréquence peut être sélectionnée de manière précise et sûre dans une gamme de fréquences prédéterminées.

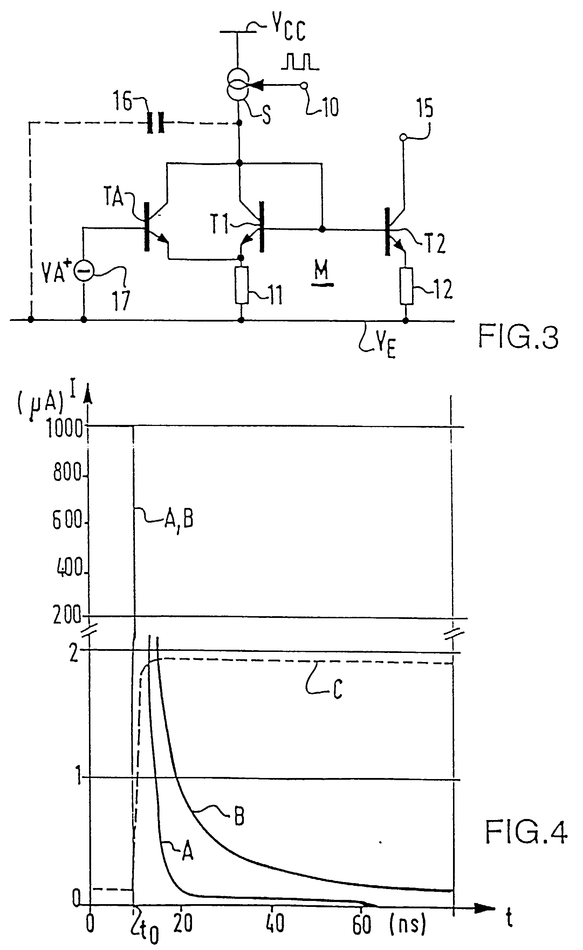

Le circuit représenté à la figure 3 comporte un miroir de courant M commandé à partir d'une source de courant de commande S qui peut prendre deux états, le premier correspondant à une valeur de courant dite nominale et le second état à une valeur de courant pratiquement nulle. La commande de cette source de courant S est symbolisée par la borne de commande 10. Un transistor T1 connecté en diode, dont l'émetteur comporte une première résistance d'équilibrage 11 forme, ensemble avec la source de courant de commande S, la branche de commande du miroir de courant M en série entre une borne d'alimentation VCC et une borne de référence de tension V_{E}. La branche de sortie du miroir de courant M comporte un transistor T2 dont l'émetteur est relié à la référence de tension V_{E} à travers une deuxième résistance d'équilibrage 12. Les transistors T1 et T2 ont leurs bases interconnectées et le collecteur du transistor T2 constitue la borne de sortie 15 du miroir de courant. Jusqu'ici le miroir de courant M est d'un type tout à fait classique avec lequel le temps de descente, lorsque la source de courant de commande S passe de son état haut à son état bas, présente un ralentissement significatif dans la région des faibles courants de sortie. En effet, le noeud qui est relié à la source de courant de commande S et au collecteur du premier transistor T1 présente une capacité parasite 16, représentée en pointillé sur la figure, dont la charge doit être évacuée principalement par le transistor T1 connecté en diode lequel a son impédance équivalente qui ne cesse de croître lorsque le courant de décharge diminue.

Selon l'invention, sur le trajet émetteur-collecteur du transistor T1 est connecté en parallèle le trajet émetteur-collecteur d'un transistor additionnel TA, dont la base est polarisée par rapport à la borne de référence V_{E} par une source de tension fixe 17 de valeur V_{A}. La tension V_{A} est choisie de telle manière que le transistor additionnel TA soit pratiquement bloqué lorsque la source de courant de commande S débite son courant nominal tandis que ce même transistor additionnel TA est conducteur lorsque la source de courant de commande S est au contraire à son état bas. Ceci est aisément réalisé en choisissant la valeur de la première résistance d'équilibrage 11 suffisamment élevée pour que la chute de tension à ses bornes, sous l'effet du courant nominal de la source de courant de commande S, soit suffisamment élevée, c'est-à-dire supérieure à 80 mV et par exemple de l'ordre de 150 mV pour bien différencier les deux états de fonctionnement du transistor additionnel TA. On choisira alors une valeur de tension V_{A} de la source de tension 17 voisine d'une chute de tension de jonction en direct, par exemple 700 mV, de sorte que le transistor additionnel TA est porté à une tension base-émetteur de seulement 550 mV (700 - 150) dans l'état passant de la source de courant de commande S (ce transistor étant donc très faiblement conducteur), tandis que lorsque la source de courant de commande S est dans son état bloqué et le courant passant dans la première résistance d' d'équilibrage 11 ayant fortement diminué, le transistor additionnel TA devient conducteur et débite par son émetteur un courant de repos sous l'effet d'une tension base-émetteur proche de 700mV (la chute de tension dans la résistance d'équilibrage 11 étant négligée). Ce courant de repos, toutefois, peut être choisi relativement faible si on le désire.

En d'autres termes, on peut considérer que les transistors T1 et TA forment une paire différentielle, le transistor TA ayant sa base polarisée à tension fixe et le transistor T1 ayant sa base polarisée à une tension décroissante. Lorsqu'au cours de la décroissance du courant, due à la décharge de la capacité parasite 16, la base du transistor T1 est à une tension qui devient inférieure à la tension de la base du transistor TA, c'est alors le transistor TA qui devient conducteur et poursuit la décharge de cette capacité parasite.

La figure 4 représente, pour un exemple de réalisation, la variation du courant de sortie I présent sur la borne de sortie 15 en fonction du temps t à partir du moment to où la source de courant de commande passe à son état bloqué. La courbe A représente l'allure de cette variation pour le circuit donné à la figure 3 tandis que la courbe B représente l'allure de cette décroissance pour un circuit miroir de courant dans lequel le transistor additionnel TA est omis. On voit sur cette figure 4 que la première partie de décroissance du courant de sortie, représentée à petite échelle, est identique pour les deux circuits ce qui n'est pas un inconvénient puisque cette première partie de décroissance est rapide. Le circuit de l'invention présente une très nette accélération du temps de descente lorsque l'on observe la partie finale à courant faible représentée à grande échelle. La courbe C indiquée en pointillé présente l'allure du courant débité par le transistor additionnel TA au cours du temps.

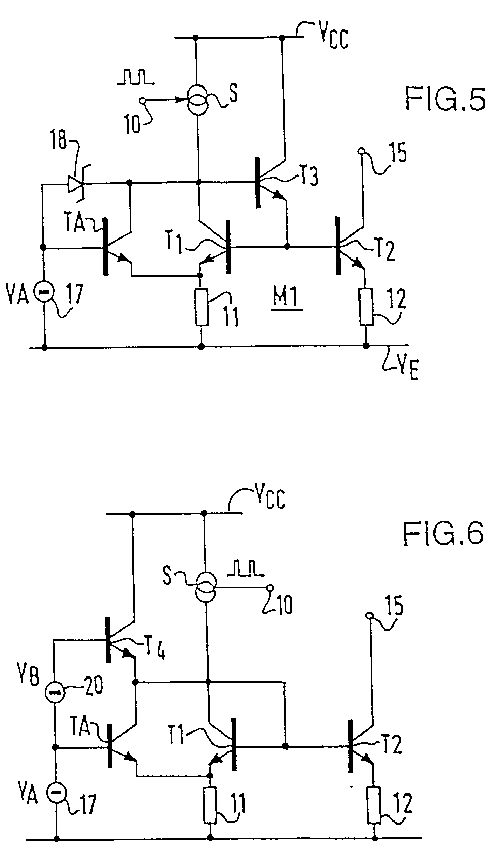

La figure 5 représente le schéma d'un deuxième exemple de circuit selon l'invention. Sur cette figure les éléments ayant la même fonction que dans le circuit de la figure 3, sont affectés des mêmes signes de référence. Le schéma de la figure 5 se distingue de celui donné à la figure 3 en ce que le miroir de courant M1 est d'un type, connu en soi, selon lequel un troisième transistor T3 est inséré dans la branche de commande du miroir de courant M1, transistor T3 qui alimente par son émetteur les deux bases des transistors T1 et T2. De même que dans le premier exemple, un transistor additionnel TA a son trajet émetteur-collecteur connecté en parallèle avec le trajet émetteur-collecteur du premier transistor T1. La base du transistor additionnel TA est également polarisée par une tension fixe V_{A}. L'effet d'accélération obtenu avec ce montage est semblable à l'effet obtenu dans le montage du premier exemple.

Dans l'exemple de la figure 5, on a également appliqué au transistor additionnel TA, un dispositif anti-saturation constitué par une diode de Schottky 18 connectée entre la base et le collecteur dudit transistor, dans un sens tel qu'elle s'oppose à ce que la tension collecteur de ce transistor rejoigne la tension de son émetteur. Un dispositif d'anti-saturation du transistor additionnel TA peut se révéler très utile selon les applications, pour éviter un retard dans le temps de montée du miroir de courant commandé, dû à la saturation de ce transistor et au délai d'évacuation des charges ainsi accumulées dans ce transistor. Le dispositif anti-saturation n'exerce pas d'influence sur le temps de descente du miroir de courant M1.

La figure 6 présente le schéma d'un troisième exemple de circuit selon l'invention, dans lequel un autre type de dispositif anti-saturation est appliqué à un circuit tel que celui de la figure 3. Il est constitué par un transistor supplémentaire T4 dont l'émetteur est connecté aux collecteurs réunis du transistor additionnel TA et du premier transistor T1, dont le collecteur est relié à la tension d'alimentation VCC et dont la base est polarisée à une tension fixe qui dépasse quelque peu la tension V_{A} des précédents exemples, par exemple au moyen d'un générateur de tension V_{B} 20 de 200 mV ce qui est l'équivalent d'une fraction seulement d'une tension de jonction polarisée en direct. Le générateur de la tension V_{B} 20 et le transistor T4 forment un dispositif anti-saturation pour le transistor additionnel TA en imposant une limite de tension collecteur-émetteur du transistor TA, correspondant sensiblement à la valeur de la tension V_{B}. Dans l'un ou l'autre cas des dispositifs anti-saturation des figures 5 ou 6, le noeud commun au collecteur des transistors TA et T1 n'est plus à même de descendre à la valeur de la tension de référence V_{E} mais c'est le transistor additionnel TA qui débite en fin de décharge, tandis que le premier transistor T1 ainsi que son homologue le transistor T2 dans le miroir de courant, ne débitent pas.

Les générateurs de tension V_{A} et V_{B} peuvent être réalisés très simplement : le générateur V_{A} étant constitué par exemple, par un transistor connecté en diode, alimenté en direct par une source de courant à partir de la borne d'alimentation VCC, tandis que le générateur de tension V_{B} est une résistance de valeur appropriée, interposée en série entre le générateur V_{A} et ladite source de courant.

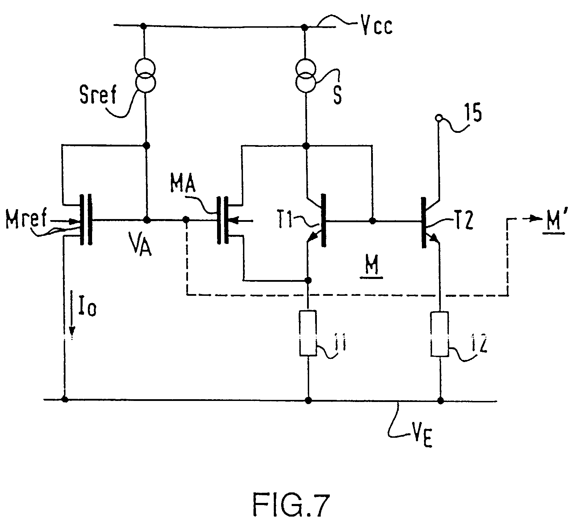

Les exemple décrits jusqu'ici mettent en oeuvre des transistors bipolaires. Toutefois, l'invention inclut également l'utilisation de transistors à effet de champ, à grille isolée par exemple, avec lesquels des résultats similaires peuvent être obtenus. Un exemple de réalisation particulièrement avantageux est décrit à l'aide de la figure 7, dont le schéma indique l'emploi de transistors bipolaires pour réaliser le miroir de courant, combinés avec des transistors à effet de champ à grille isolée (MOS) pour réaliser la fonction d'accélération du temps de descente du miroir.

A la figure 7, le miroir de courant M est constitué des mêmes éléments que ceux représentés à la figure 3, lesquels sont affectés des mêmes signes de référence. Le transistor dit additionnel est ici un transistor MA du type MOS à canal n, dont le trajet drain-source est connecté en parallèle sur le trajet collecteur-émetteur du premier transistor T1. Pour réaliser la tension fixe V_{A} nécessaire à la polarisation de la grille du transistor additionnel MA, il est prévu un autre transistor Mref, de même type que le transistor MA, dont la source est reliée à la tension de référence V_{E}, dont la grille et le drain sont reliés ensemble, et alimentés à partir de la tension d'alimentation Vcc, par une source de courant Sref débitant un courant Io fixé.

Le noeud de connexion drain-grille du transistor Mref présente la tension V_{A} recherchée, qui est appliquée à la grille du transistor additionnel MA. Comme la transconductance d'un transistor MOS n'est pas aussi élevée que celle d'un transistor bipolaire, il est utile d'augmenter sensiblement la valeur des résistances d'équilibrage 11 et 12 pour obtenir des résultats équivalents à ceux des exemples précédents, n'utilisant que des transistors bipolaires.

Ce montage présente plusieurs avantages. En effet, le transistor additionnel MA n'est pas sujet, par nature, à la saturation. D'autre part, la commande de la grille du transistor additionnel MA, se fait sans consommation de courant. Il est ainsi possible de commander, à l'aide d'un seul transistor Mref, plusieurs miroirs de courant susceptibles de fonctionner en parallèle, pour l'absorption de courants élevés dans le circuit de pompe de charges. Cette possibilité à été représentée symboliquement par la liaison en tirets, pour la commande d'au moins un miroir de courant supplémentaire M'. A chacun de ces miroirs M' est adjoint, bien entendu, un transistor additionnel tel que le transistor MA.

Les circuits décrits en liaison avec les figures 3 à 7 s'appliquent avantageusement à la réalisation d'une pompe de charge dans une boucle à verrouillage de phase d'un synthétiseur de fréquence. Dans une telle application, deux sources de courant commandées cycliquement, ont pour rôle de contrôler une tension de charge déterminée aux bornes d'un condensateur. Ces deux sources de courant à commande cyclique sont construites de manière identique de manière à procurer des courants ayant les mêmes temps de montée et de descente. Le courant de l'une de ces sources de courant est renvoyé avec le signe inverse au moyen d'un miroir de courant. Au moyen de l'invention, on rétablit, en sortie du miroir de courant, un courant dont le temps de descente est pratiquement identique au temps de descente de la source de courant qui lui est opposée. Ainsi la fluctuation de tension aux bornes du condensateur, qui se produit en l'absence des dispositions de l'invention et a une forme en dent de scie, se trouve pratiquement éliminée.

Dans les exemples précédemment décrits, tous les transistors bipolaires sont de type npn et les transistors MOS sont à canal n. Il est clair que l'invention s'applique également à un circuit utilisant des transistors de type opposé pour lequel les bornes d'alimentation sont changées de signe.

L'invention s'appliquant indifféremment à des transistors bipolaires ou à des transistors à effet de champ, on comprendra qu'à cet effet, l'expression "trajet principal de courant" désigne le trajet collecteur-émetteur d'un transistor bipolaire ou le trajet drain-source d'un transistor à effet de champ, tandis que par "électrode de commande", on désigne la base d'un transistor bipolaire ou la grille d'un transistor à effet de champ, et que l'expression "électrode de référence" désigne l'émetteur d'un transistor bipolaire ou la source d'un transistor à effet de champ.

D'autres modifications possibles par rapport aux exemples décrits, restent néanmoins du domaine de l'invention revendiquée ci-après.

## Revendications

1. Miroir de courant (M) constitué d'une branche de commande et d'une branche de sortie,
la branche de commande comportant, en série entre une borne d'alimentation (Vcc) et une borne de référence de tension (V_{E}) :
- une source de courant de commande (S) commutable selon deux états, un état pour lequel un courant de commande de valeur nominale est débité, et un état bloqué,
- le trajet principal de courant d'au moins un premier transistor (Tl),
- et une première résistance d'équilibrage (11),
et la branche de sortie du miroir comportant un deuxième transistor (T2), prévu pour fournir un courant dont la valeur est en relation déterminée avec le courant de commande, et dont l'électrode de référence est reliée à la borne de référence de tension (V_{E}) à travers une deuxième résistance d'équilibrage (12), les électrodes de commande des premier (T1) et deuxième (T2) transistors étant interconnectées et polarisées à partir du courant de commande,
caractérisé en ce qu'il comporte un transistor additionnel (TA) dont le trajet principal de courant est connecté en parallèle avec le trajet principal de courant du premier transistor (T1), transistor additionnel dont l'électrode de commande est polarisée par une tension fixe (VA) de valeur déterminée de telle façon que dans la paire différentielle formée par le premier transistor (T1) et le transistor additionnel (TA) et sous l'effet de la chute de tension dans la première résistance d'équilibrage qui varie avec le courant de commande, le transistor additionnel soit pratiquement bloqué lorsque la source de courant de commande (S) débite un courant de commande nominal, et devienne conducteur lorsque cette source passe à l'état bloqué.

2. Miroir de courant selon la revendication 1, caractérisé en ce que la chute de tension dans la première résistance d'équilibrage (11) sous l'effet du courant de commande est supérieure à 80 mV.

3. Miroir de courant selon l'une des revendications 1 ou 2, dans lequel le transistor additionnel (TA) est un transistor bipolaire, caractérisé en ce que ce transistor additionnel (TA) est muni d'un dispositif anti-saturation.

4. Miroir de courant selon la revendication 3, caractérisé en ce que le dispositif anti-saturation est constitué d'une diode Schottky (18) connectée entre la base et le collecteur du transistor additionnel (TA).

5. Miroir de courant selon la revendication 3, caractérisé en ce que le dispositif anti-saturation est constitué d'un transistor supplémentaire (T4), dont l'émetteur est connecté au collecteur du premier transistor (T1) et à celui du transistor additionnel (TA), dont la base est polarisée à une autre tension fixe (VA+VB) qui dépasse la tension fixe (VA) précédemment mentionnée d'une fraction d'une tension de jonction polarisée en direct, et dont le collecteur est alimenté à partir de la borne d'alimentation (VCC).

6. Miroir de courant selon l'une des revendications 1 ou 2, dans lequel les premier et deuxième transistors sont des transistors bipolaires, caractérisé en ce que le transistor additionnel (MA) est un transistor à effet de champ.

7. Miroir de courant selon la revendication 6, caractérisé en ce que ladite tension fixe déterminée est fournie par un autre transistor à effet de champ (Mref), dont la grille et le drain sont interconnectés et alimentés, à partir de la borne d'alimentation (VCC), par un courant (Io) fixé qui est délivré par une source de courant de référence (Sref), tandis que la source de cet autre transistor est reliée à la borne de référence de tension (V_{E}), ladite tension fixe déterminée (VA) étant disponible sur le noeud drain-grille dudit autre transistor (Mref).

8. Synthétiseur de fréquence dans lequel un signal de sortie (Vfr) est fourni par un oscillateur (1) à fréquence commandable par une tension développée sur une capacité (C) par un circuit pompe de charge (2) comprenant deux sources de courant (7, 8) de construction semblable et commandées séparément par des signaux (UP, DWN) en sortie d'un comparateur de phase (3) qui reçoit en entrée, d'une part, le signal de sortie de l'oscillateur après passage dans un diviseur de fréquence (4) et d'autre part, un signal issu d'un oscillateur de référence (5), et comprenant un miroir de courant, caractérisé en ce que le courant de l'une (7) des sources de courant, commutable selon deux états, un état débitant un courant nominal et un état bloqué, sert de courant de commande pour ledit miroir de courant (9) dont une branche de commande comporte un premier transistor (T1) muni d'une première résistance d'équilibrage (11) et dont une branche de sortie comporte un deuxième transistor (T2) muni d'une deuxième résistance d'équilibrage (12), miroir de courant comprenant en outre un transistor additionnel (TA) dont le trajet principal de courant est connecté en parallèle sur le trajet principal de courant du premier transistor (T1), l'électrode de commande du transistor additionnel étant polarisée par une tension fixe (VA) d'une valeur déterminée de telle façon que dans la paire différentielle formée par le premier transistor (T1) et le transistor additionnel (TA) et sous l'effet de la chute de tension dans la première résistance d'équilibrage, le transistor additionnel soit pratiquement bloqué lorsque la source de courant de commande (S) débite un courant de commande nominal, et devienne conducteur lorsque cette source passe à l'état bloqué.

9. Appareil radio-mobile comportant un synthétiseur de fréquence muni d'un circuit pompe de charge dans lequel le courant d'une source de courant, commutable selon deux états, un état débitant un courant nominal et un état bloqué, sert de courant de commande pour un miroir de courant, caractérisé en ce que ce miroir de courant (M) comprend un transistor additionnel (TA, MA) dont le trajet principal de courant est connecté en parallèle sur le trajet principal de courant d'un premier transistor (T1) lequel constitue la branche de commande du miroir et est muni d'une première résistance d'équilibrage (11), tandis qu'un deuxième transistor (T2) muni d'une deuxième résistance d'équilibrage (12) constitue une branche de sortie du miroir, et en ce que l'électrode de commande du transistor additionnel est polarisée par une tension fixe (VA) dont la valeur est déterminée de telle façon que dans la paire différentielle formée par le premier transistor (T1) et le transistor additionnel (TA, MA)) et sous l'effet de la chute de tension dans la première résistance d'équilibrage, le transistor additionnel soit pratiquement bloqué lorsque la source de courant de commande (S) débite un courant de commande nominal, et devienne conducteur lorsque cette source passe à l'état bloqué.

## Patentansprüche

1. Ein aus einem Steuerzweig und einem Ausgangszweig gebildeter Stromspiegel (M),
der Steuerzweig enthält in Serie zwischen einem Versorgungsanschluß (Vcc) und einem Spannungsreferenzsanschluß (V_{E}):
- eine Steuerstromquelle (S), schaltbar entsprechend zwei Zuständen, für einen Zustand wird ein Steuerstrom nominalen Wertes abgegeben, und ein Zustand ist gesperrt,
- den Hauptstromweg von mindestens einem ersten Transistor (T1)
- und einen ersten Ausgleichswiderstand (11),
und der Ausgangszweig des Stromspiegels enthält einen zweiten Transistor (T2), der vorgesehen ist, um einen Strom eines Wertes in einem bestimmten Verhältnis mit dem Steuerstrom zu liefern und dessen Referenzelektrode über einen zweiten Ausgleichswiderstand (12) mit dem Spannungsreferenzsanschluß (V_{E}) verbunden ist, wobei die Steuerelektroden des ersten (T1) und zweiten (T2) Transistors miteinander verbunden sind und vom Steuerstrom polarisiert werden,
mit dem Merkmal, daß er einen zusätzlichen Transistor (TA) enthält, dessen Hauptstromweg parallel mit dem Hauptstromweg des ersten Transistors (T1) geschaltet ist, wobei die Steuerelektrode des zusätzlichen Transistors mit einer Festspannung (VA) eines bestimmten Wertes so polarisiert ist, daß in dem vom ersten Transistor (T1) und dem zusätzlichen Transistor (TA) gebildeten differentiellen Paar und unter dem Effekt des Spannungsabfalls im ersten Ausgleichswiderstand, der mit dem Steuerstrom schwankt, der zusätzliche Transistor quasi gesperrt ist, wenn die Steuerstromquelle (S) einen nominalen Steuerstrom abgibt, und leitend wird, wenn diese Quelle in den gesperrten Zustand übergeht.

2. Ein Stromspiegel laut Anspruch 1, mit dem Merkmal, daß der Spannungsabfall im ersten Ausgleichswiderstand (11) unter dem Effekt des Steuerstroms über 80 mV liegt.

3. Ein Stromspiegel laut einem der Ansprüche 1 oder 2, in dem der zusätzliche Transistor (TA) mit einer Anti-Sättigungseinrichtung versehen ist.

4. Ein Stromspiegel laut Anspruch 3, mit dem Merkmal, daß die Anti-Sättigungseinrichtung aus einer Schottky-Diode (18) gebildet wird, die zwischen der Basis und dem Kollektor des zusätzlichen Transistors (TA) angeschlossen ist.

5. Ein Stromspiegel laut Anspruch 3, mit dem Merkmal, daß die Anti-Sättigungseinrichtung aus einem zusätzlichen Transistor (T4) gebildet wird, dessen Emitter mit dem Kollektor des ersten Transistors (T1) und dem des zusätzlichen Transistors (TA) verbunden ist, dessen Basis mit einer anderen Festspannung (VA+VB) polarisiert ist, die die zuvor genannte Festspannung (VA) um den Bruchteil einer direktpolarisierten Verbindungsspannung übersteigt, und dessen Kollektor vom Versorgungsanschluß (VCC) versorgt wird.

6. Ein Stromspiegel laut einem der Ansprüche 1 oder 2, in dem der erste und der zweite Transistor zweipolige Transistoren sind, mit dem Merkmal, daß der zusätzliche Transistor (MA) ein Feldeffekttransistor ist.

7. Ein Stromspiegel laut Anspruch 6, mit dem Merkmal, daß die besagte, festgelegte Festspannung von einem anderen Feldeffekttransistor (Mref) geliefert wird, dessen Gitter und Drain miteinander verbunden sind und vom Versorgungsanschluß (VCC) mit einem Feststrom (Io) versorgt werden, der von einer Referenzstromquelle (Sref) abgegeben wird, während die Source des anderen Transistors mit dem Referenzspannungsanschluß (V_{E}) verbunden ist und die besagte Festspannung (VA) auf dem Knoten Drain-Gitter des besagten anderen Transistors (Mref) verfügbar ist.

8. Ein Frequenzaufbereiter, in den ein Ausgangssignal (Vfr) von einem Oszillator (1) mit steuerbarer Frequenz geliefert wird, über eine Spannung, die auf einer Kapazität (C) von einer Ladepumpenschaltung (2) erzeugt wird, mit zwei Stromquellen (7, 8) ähnlicher Bauweise, getrennt über die Signale (UP, DWN) am Ausgang eines Phasenvergleichers (3) gesteuert, der am Eingang einerseits das Ausgangssignal des Oszillators nach dem Durchlaufen eines Frequenzteilers (4) und andererseits ein aus einem Referenzoszillator (5) herrührendes Signal erhält und einen Stromspiegel enthält, mit dem Merkmal, daß der Strom einer (7) der Stromquellen, schaltbar nach zwei Zuständen, ein Zustand mit nominaler Stromabgabe und ein gesperrter Zustand, als Steuerstrom für den besagten Stromspiegel (9) dient, wobei ein Steuerzweig einen ersten Transistor (T1) enthält, versehen mit einem ersten Ausgleichswiderstand (11), und wobei ein Ausgangszweig einen zweiten Transistor (T2) enthält, versehen mit einem zweiten Ausgleichswiderstand (12), und der Stromspiegel außerdem einen zusätzlichen Transistor (TA) enthält, dessen Hauptstromweg parallel zum Hauptstromweg des ersten Transistors (T1) geschaltet ist, wobei die Steuerelektrode des zusätzlichen Transistors über eine Festspannung (VA) eines bestimmten Wertes polarisiert ist, derart, daß im ersten, vom ersten Transistor (T1) und dem zusätzlichen Transistor (TA) gebildeten differentiellen Paar und unter dem Effekt des Spannungsabfalls im ersten Ausgleichswiderstand der zusätzliche Transistor praktisch gesperrt ist, wenn die Steuerstromquelle (S) einen nominalen Steuerstrom abgibt, und leitend wird, wenn diese Stromquelle in den gesperrten Zustand übergeht.

9. Ein mobiles Funkgerät mit einem Frequenzaufbereiter, versehen mit einer Ladepumpenschaltung, in der der Strom einer Stromquelle, schaltbar nach zwei Zuständen, ein Zustand mit nominaler Stromabgabe und ein gesperrter Zustand, als Steuerstrom für einen Stromspiegel dient, mit dem Merkmal, daß dieser Stromspiegel (M) einen zusätzlichen Transistor (TA, MA) enthält, dessen Hauptstromweg parallel zum Hauptstromweg des ersten, den Steuerzweig des Spiegels bildenden Transistor (T1) geschaltet ist und mit einem ersten Ausgleichswiderstand (11) versehen ist, während ein zweiter, mit einem zweiten Ausgleichswiderstand (12) versehener Transistor (T2) einen Ausgangszweig des Spiegels bildet, und daß die Steuerelektrode des zusätzlichen Transistors über eine Festspannung (VA) polarisiert ist, deren Wert derart festgelegt ist, daß in dem vom ersten Transistor (T1) und dem zusätzlichen Transistor (TA, MA) gebildeten differentiellen Paar und unter dem Effekt des Spannungsabfalls im ersten Ausgleichswiderstand der zusätzliche Transistor praktisch gesperrt ist, wenn die Steuerstromquelle (S) einen nominalen Steuerstrom abgibt, und leitend wird, wenn diese Stromquelle in den gesperrten Zustand übergeht.

## Claims

1. A current mirror circuit (M) comprising a control branch and an output branch, the control branch including in a series combination between a power supply terminal (Vcc) and a reference voltage terminal (V_{E}):
- a switchable control current source (S) which may adopt two states, one state for which a control current of nominal value is delivered, and a blocked state,
- the main current path of at least a first transistor (T1),
- and a first balance resistor (11),
and the output branch of the mirror circuit comprising a second transistor (T2), for producing a current whose value has a given relation to the control current, and whose reference electrode is connected to the reference voltage terminal (V_{E}) through a second balance resistor (12), the control electrode of the first (T1) and that of the second transistor (T2) being interconnected and biased with the control current, characterized in that the current mirror circuit includes an additional transistror (TA) whose main current path is connected in parallel with the main current path of the first transistor (T1), of which additional transistor (TA) the control electrode is biased with a fixed voltage (VA) having a value determined in such a way that in the differential pair formed by the first transistor (T1) and the additional transistor (TA) and under the influence of the voltage drop in the first first balance resistor which varies with the control current, the additional transistor is practically cut-off when the control current source (S) delivers a nominal control current, and is conductive when this source is blocked.

2. A current mirror circuit as claimed in Claim 1, characterized in that the voltage drop in the first balance resistor (11) exceeds 80 mV under the influence of the control current.

3. A current mirror circuit as claimed in one of the Claims 1 or 2, in which the additional transistor (TA) is a bipolar transistor, characterized in that this additional transistor (TA) comprises an anti-saturation device.

4. A current mirror circuit as claimed in Claim 3, characterized in that the anti-saturation device is formed by a Schottky diode (18) connected in parallel with the base and the collector of the additional transistor (TA).

5. A current mirror circuit as claimed in Claim 3, characterized in that the anti-saturation device is formed by a supplementary transistor (T4) whose emitter is connected to the collector of the first transistor (T1) and to that of the additional transistor (TA), whose base is biased with another fixed voltage (VA+VB) which exceeds the previously mentioned fixed voltage (VA) by a fraction of a forward biased junction voltage, and whose collector is fed from the power supply terminal (VCC).

6. A current mirror circuit as claimed in one of the Claims 1 or 2, in which the first and second transistors are bipolar transistors, characterized in that the additional transistor (MA) is a field effect transistor.

7. A current mirror circuit as claimed in Claim 6, characterized in that said determined fixed voltage is supplied by another field effect transistor (Mref) whose drain and gate are interconnected and supplied from the power supply terminal (VCC) with a fixed current (Io) produced by a reference current source (Sref), whereas the source of this other transistor is connected to the reference voltage terminal (V_{E}) said determined fixed voltage (VA) being available on the drain-gate junction of said other transistor (Mref).

8. A frequency synthesizer in which an output signal (Vfr) is produced by an oscillator (1) having a frequency that can be controlled by a voltage developed on a capacitor (C) by a charge pump circuit (2) with two similarly constructed current sources (7, 8) and separately controlled by signals (UP, DWN) on the output of a phase comparator (3) which receives on its input, on the one hand, the output signal of the oscillator once it has passed through a frequency divider (4), and on the other hand, a signal coming from a reference oscillator (5), and comprising a current mirror circuit, characterized in that the current of one (7) of the two-state switchable current sources, one state producing a nominal current and one blocked state, is used as a control current for said current mirror (9) of which a control branch comprises a first transistor (T1) including a first balance resistor (11) and of which an output branch comprises a second transistor (T2) including a second balance resistor (12), the current mirror circuit further including an additional transistor (TA) whose main current path is connected in parallel with the main current path of the first transistor (T1), of which additional transistor (TA) the control electrode is biased with a fixed voltage (VA) having a value determined in such a way that in the differential pair formed by the first transistor (T1) and the additional transistor (TA) and under the influence of the voltage drop in the first first balance resistor, the additional transistor is practically cut-off when the control current source (S) delivers a nominal control current, and is conductive when this source is blocked.

9. A mobile radio set comprising a frequency synthesizer which includes a charge pump circuit in which the current of a two-state switchable current source, one state producing a nominal current and one blocked state, is used as a control current for a current mirror, characterized in that this current mirror (M) includes an additional transistor (TA, MA) whose main current path is connected in parallel with the main current path of a first transistor (T1) which forms the current mirror control branch, and includes a first balance resistor (11), whereas a second transistor (T2) including a second balance resistor (12) forms a current mirror output branch, and in that the control electrode of the additional transistor is biased with a fixed voltage (VA) having a value determined in such a way that in the differential pair formed by the first transistor (T1) and the additional transistor (TA, MA) and under the influence of the voltage drop in the first balance resistor, the additional transistor is practically cut-off when the control current source (S) produces a nominal control current, and is conductive when this source is in the blocked state.
